# EUROPÄISCHE PATENTSCHRIFT

(11) **EP 2 088 621 B1**
(45) Veröffentlichungstag und Bekanntmachung des Hinweises auf die Patenterteilung: **08.12.2010**
(21) Anmeldenummer: 08002322.9
(22) Anmeldetag: 08.02.2008
(51) Int. Cl.: H01L 21/677

(54) **Substratträger**
Substrate carrier
Support de substrat

(43) Veröffentlichungstag der Anmeldung: 12.08.2009
(73) Patentinhaber: RENA GmbH, 78148 Gütenbach (DE)
(72) Erfinder: Renn, Siegfried, 78727 Oberndorf am Neckar (DE)
(74) Vertreter: Späth, Dieter

(56) Entgegenhaltungen:
- WO-A-87/00094
- JP-A- 2004 039 721
- JP-A- 2005 217 258
- US-A1- 2003 202 871

## Beschreibung

Substratträger zur zeitweiligen lagefixierten Aufnahme einer Anzahl von plattenförmigen Substraten in vertikaler Ausrichtung als liegender Stapel, mit einem von außen aus mehreren Richtungen zugänglichen, vorzugsweise länglichen Innenraum, an dessen Stirnenden zwei einander gegenüberliegende starr miteinander verbundene Stirnelemente angeordnet sind, und mit mindestens einem unteren Trageelement für die Substrate, das sich zwischen den Stirnelementen erstreckt und in der Gebrauchslage des Substratträgers aufgenommene Substrate von unten her abstützt. Unter plattenförmigen Substraten werden prinzipiell alle flachen ebenen Körper verstanden, deren Weitenerstreckung im Vergleich zur Dicke erheblich ist.

Üblicherweise sind Substratträger zum Aufbewahren, zum Halten und zum Transport von Substraten, beispielsweise von Wafern, in senkrechten Ebenen konstruiert. Solche Substrate werden häufig aus einem blockförmigen einstückigen Substratgrundkörper hergestellt, der bei Wafern aus Silizium besteht. Zur Erzeugung der plattenförmigen Substrate wird der Substratgrundkörper durch ein geeignetes Trennverfahren in einzelne Platten zerlegt.

Die Herstellung der einzelnen plattenförmigen Substrate erfolgt durch das Trennen des an einer Verbindungsplatte angebrachten Substratgrundkörpers, beispielsweise mit Hilfe einer besonderer Säge, wobei die einzelnen Substrate nach dem Trennvorgang gemeinsam aufeinanderfolgend in einem geringen Abstand zueinander angeordnet und über die Verbindungsplatte noch miteinander verbunden sind. Die über die Verbindungsplatte noch miteinander verbundenen Substrate müssen zur weiteren Verwendung anschließend noch vereinzelt werden.

Zum Vereinzeln der Substrate wird der zerlegte Substratgrundkörper zusammen mit der Verbindungsplatte in der Regel derart in einen Substratträger eingesetzt, dass die Substrate in vertikaler Ausrichtung als liegender Stapel von dem Substratträger getragen werden und die Verbindungsplatte in horizontaler Lage darüber angeordnet ist. Üblicherweise wird die Verbindungsplatte, beispielsweise eine Glasplatte, mittels einer Klebestrecke vor dem Sägen an dem Substratgrundkörper befestigt, so dass die einzelnen Substrate nach dem Sägen des Grundkörpers lediglich mittels dem Kleber an der Verbindungsplatte haften.

Bekannte Substratträger weisen häufig einen von außen aus mehreren Richtungen zugänglichen Innenraum auf, an dessen Stirnenden zwei einander gegenüberliegende, starr miteinander verbundene Stirnelemente angeordnet sind. Zwischen den Stirnelementen verläuft in Längsrichtung mindestens ein in der Gebrauchslage des Substratträgers unten positioniertes Trageelement für die aufzunehmenden Substrate, das die Substrate von unten her abstützt.

Vor der weiteren Verwendung der Substrate ist nach dem Sägevorgang ein Reinigungsvorgang notwendig, um die beim Trennvorgang des Substratgrundkörpers anfallenden Abraumpartikel möglichst vollständig von der Oberfläche der Substrate zu entfernen. Zur Reinigung wird der Substratträger mit den darin aufgenommen Substraten quer zur Stapelrichtung mit einem Fluidstrom beaufschlagt. Der Fluidstrom kann aus einem Fluidstrahl oder mehreren Fluidstrahlen gebildet sein. Die Reinigung erfolgt dabei meistens in einem Reinigungsbad, das eine Reinigungsflüssigkeit enthält, wobei der Fluidstrom von mindestens einer Reinigungsdüse ausgeht, die vorzugsweise ein- oder beidseitig seitlich des Substratträgers in dem Reinigungsbad angeordnet ist.

Nach dem Reinigungsvorgang wird der Substratträger in ein Lösungsbad umgesetzt, das die Klebestrecke zwischen der Verbindungsplatte und den einzelnen Substraten auflöst, so dass die Verbindungsplatte von den Substraten entfernt werden kann. Nach dem Entfernen der Verbindungsplatte stehen die einzelnen Substrate zur Weiterverarbeitung vereinzelt zur Verfügung und werden von dem Substratträger in der vorgegebenen Position gehalten. Sie können nacheinander schrittweise in senkrechter Ausrichtung aus dem Substratträger entnommen werden.

Derartige bekannte Substratträger werden zum Beispiel im US-A1-2003/202 871 oder WO-A-87/00094 offenbart.

Es ist die Aufgabe der vorliegenden Erfindung, einen Substratträger der eingangs genannten Art so weiterzubilden, dass die aufgenommenen Substrate, auch mittels Robotertechnik, in diesen schnell und einfach einführbar sowie aus diesen entnehmbar sind und darin in zuverlässiger Weise aufbewahrbar, transportierbar sowie reinigbar sind.

Diese Aufgabe wird erfindungsgemäß durch einen Substratträger mit den Merkmalen des Anspruchs 1 gelöst. Weitere vorteilhafte Ausgestaltungen sind den Unteransprüchen zu entnehmen.

Danach weist der erfindungsgemäße Substratträger seitliche Stützelemente für die Substrate auf, die beidseitig in Längsrichtung zwischen den Stirnelementen verlaufen und deren Höhe gegenüber dem unteren Trageelement veränderbar ist. Die seitlichen Stützelemente dienen zum seitlichen Abstützen der einzelnen Substrate, nachdem die Verbindungsplatte abgelöst und von dem liegenden Stapel der Substrate entfernt worden ist.

Solange die Substrate noch mit der Verbindungsplatte verbunden sind, ist eine seitliche Abstützung des Stapels nicht unbedingt erforderlich. Zweckmäßigerweise können die Stützelemente, beispielsweise für einen Reinigungsvorgang, bis auf das Niveau des mindestens einen unteren Tragelements abgesenkt werden, so dass die seitlichen Kanten der Substrate frei liegen und die Zwischenräume zwischen den Substraten gut zugänglich sind. Während feststehende seitliche Stützelemente bei herkömmlichen Substratträgern zumindest einen Teil der Oberfläche der zu reinigenden Substrate vor dem seitlich auf den Substratträger gerichteten Fluidstrom schützen, stören die in ihrer Höhe veränderbaren Stützelemente, bei vollständiger Absenkung, den Reinigungsvorgang nicht. Die Substrate können problemlos und vollständig gereinigt werden.

Weiterer Vorteil ist, dass die Höhe der Stützelemente an unterschiedliche Größen von Substraten einfach und schnell anpassbar ist. Dies kann entweder manuell oder automatisch erfolgen. Dabei ist es außerdem zweckmäßig, die Stützelemente mindestens auf einer mittleren Höhe der Substrate, besser noch nahe der oberen Kante an den Substraten angreifen zu lassen, um diese möglichst lagestabil zu fixieren.

Vorteilhafterweise weisen die seitlichen Stützelemente vorzugsweise an beiden Enden beidseitig eine lösbare Verriegelung zu den Stirnelementen des Substratträgers auf. Dazu sind die Stirnelemente mit korrespondierenden Einrichtungen versehen, die in einer oder verschiedenen Höhen gegenüber dem Trageelement ausgebildet sind. Dies ermöglicht die Stützelemente in geeigneter Höhe gegenüber den aufgenommen Substraten, d.h. in einem gewünschten Abstand zu dem unteren Trageelement an den Stirnelementen lösbar festzulegen.

In einer bevorzugten Ausführungsform der Erfindung weisen die Stützelemente mindestens ein nach außen abstehendes Betätigungselement auf. Mittels dem Betätigungselement kann Einfluss auf die Höhe des jeweiligen Stützelementes gegenüber dem Trageelement genommen werden. Dazu kann in einer den Substratträger aufnehmenden Vorrichtung, beispielsweise in einem Reinigungs-und/oder Lösemittelbad, mit Hilfe einer daran angreifenden Stelleinrichtung die Höhe des Stützelementes individuell und aufgabenbezogen eingestellt werden.

Vorteilhaft ist insbesondere eine Ausführungsform des erfindungsgemäßen Substratträgers, bei der die seitlichen Stützelemente von einer verschiebbar geführten Lamellenwand vergleichbar einem (Miniatur-) Rolladen gebildet sind. Mit einer solchen Lamellenwand können die besonders empfindlichen Seitenkanten der Substrate über ihre gesamte Höhe vor Beschädigungen geschützt werden. Dazu sind an den Stirnelementen entsprechende Führungsschienen für die Lamellen der Lamellenwand vorgesehen. Dabei können die Lamellen zur Veränderung der Höhe der Lamellenwand entweder nur verschoben und/oder wie ein Rolle aufgerollt oder gefaltet werden. Die Lamellen können ohne Abstand aufeinander folgen oder Abstand voneinander aufweisen.

In einer besonderen Ausgestaltung der Erfindung ist die Lamellenwand von den seitlichen Längsseiten des Substratträgers zu der dem Trageelement zugeordneten Unterseite des Substratträgers verschiebbar. Dabei wird die Lamellenwand an dem Übergang der Längsseite zu der Unterseite des Substratträgers in einem Winkel, vorzugsweise um 90 Grad, umgelenkt. Bei ganz oder teilweise abgesenkter Lamellenwand verschließen die Lamellen den Substratträger von unten und schützen somit die untere Kante der Substrate vor möglichen Beschädigungen. Dabei können die Lamellen der zwei vorgesehenen Lamellenwände an der Unterseite des Substratträgers einander ganz oder teilweise überdecken, also in verschiedenen Ebenen angeordnet sein, oder aneinander anschließend, also in einer Ebene miteinander fluchtend.

In einer Ausführungsform der Erfindung bilden an der Unterseite des Substratträgers positionierte untere Lamellen der Lamellenwand das Tragelement für die Substrate. Die Substrate stehen also mit ihrem unteren Rand auf einer oder mehreren Lamellen der Lamellenwand auf. Damit ist das Trageelement für die Substrate in Querrichtung des Substratträgers verschiebbar und kann für unterschiedlich große Substrate jeweils passend eingestellt werden. Somit kann auf ein gesondert ausgeführtes Trageelement für die Substrate verzichtet werden, das sich parallel zu den unteren Lamellen der Lamellenwand zwischen den Stirnelementen erstreckt.

In einer weiteren bevorzugten Ausführungsform der Erfindung weisen die Stützelemente auf der den Substraten zugeordneten Seite seitlich zum Innenraum abstehende Borsten auf. Die Borsten halten die Substrate besonders schonend und greifen zumindest teilweise in die Zwischenräume zwischen den Substraten. Sie verhindern ein Berühren der empfindlichen Oberflächen der Substrate weitgehend und halten die Substrate mit Abstand voneinander, also vereinzelt.

Nachfolgend wird die Erfindung anhand eines Ausführungsbeispiels näher erläutert. Weitere Merkmale der Erfindung ergeben sich aus der beigefügten Zeichnung und der Beschreibung des Ausführungsbeispiels in Verbindung mit den Ansprüchen. Die einzelnen Merkmale der Erfindung können für sich allein oder zu mehreren bei verschiedenen Ausführungsformen der Erfindung verwirklicht sein. Es zeigen:
- Figur 1: einen erfindungsgemäßen Substratträger in perspektivischer Ansicht;
- Figur 2: eine Stirnseitenansicht des Substratträgers aus Figur 1;
- Figur 3: eine Seitenansicht der seitlichen Längsseiten des Substrat- trägers aus Figur 1; und
- Figur 4: eine Draufsicht auf eine obere Längsseite des Substratträgers aus Figur 1.

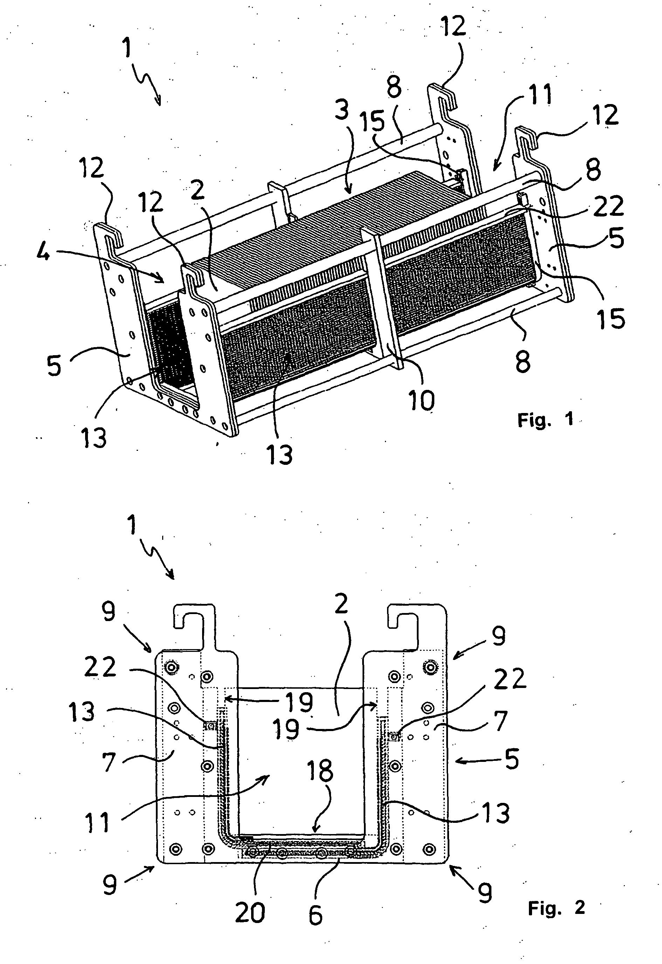

Figur 1 zeigt einen erfindungsgemäßen Substratträger 1 mit einer Anzahl von plattenförmigen Substraten 2, die in vertikaler Ausrichtung als liegender Stapel 3 in einem Innenraum 4 des Substratträgers 1 lagefixiert aufgenommen sind. Der Substratträger 1 sowie der Innenraum 4 weisen in dem dargestellten Ausführungsbeispiel eine längliche Form auf, an deren Stirnenden jeweils Stirnelemente 5 angeordnet sind. Die längliche Form ist jedoch nicht zwingend, prinzipiell kann eine Länge des Innenraums 4 auch kürzer sein als eine Erstreckung seiner Querschnittsfläche.

Die Stirnelemente 5 sind im wesentlich U-förmig ausgebildet, wobei in der üblichen Gebrauchslage des Substratträgers 1 eine Basis 6 horizontal und zwei Schenkel 7 vertikal verlaufen. Die zwei Stirnelemente 5 sind mittels vier Längsstangen 8 starr miteinander verbunden, die von Ecken 9 der Stirnelemente 5 ausgehen. Mittig zwischen den Stirnelementen 5 ist ein Mittelelement 10 vorgesehen, das wie die Stirnelemente 5 U-förmig ausgebildet ist. Das Mittelelement 10 ist von den vier Längsstangen 8 getragen und erhöht die Stabilität des Substratträgers 1.

Der von den Stirnelementen 5, dem Mittelelement 10 und den Längsstangen 8 bestimmte Innenraum 4 ist von außen aus allen Richtungen zugänglich. Insbesondere hat ein in der Zeichnung nicht dargestelltes Entnahmesystem für die Substrate 2 durch eine von der Basis 6 und den Schenkeln 7 begrenzte Ausnehmung 11 der Stirnelemente 5 Zugang zu dem Innenraum 4. Außerdem sind an den Schenkeln 7 jeweils Haken 12 ausgebildet, um den Substratträger 1 mit einer in der Zeichnung ebenfalls nicht dargestellten Greifvorrichtung greifen und transportieren zu können.

Zwischen den Stirnelementen 5 erstrecken sich beidseitig in Längsrichtung des Substratträgers 1 seitliche Stützelemente 13 in Form von Lamellenwänden. Die Lamellenwände 13 weisen eine Anzahl von senkrecht zu den Stirnelementen 5 verlaufenden, miteinander verbundenen Lamellen 14 auf. Eine Höhe der Lamellenwand 13 ist gegenüber der Basis 6 der Stirnelemente 5 vorzugsweise stufenlos veränderbar. Dazu sind die Lamellen 14, wie aus der Figur 2 ersichtlich, in L-förmigen Führungsschienen 15 verschiebbar geführt, die nach innen gerichtet an den Stirnelementen 5 angeordnet sind. Die Führungsschienen 15 erstrecken sich jeweils entlang den Schenkeln 7 und der Basis 6 der Stirnelemente 5. Darin sind die Lamellen 14 von seitlichen Längsseiten 16 zu einer Unterseite 17 des Substratträgers 1 und umgekehrt verschiebbar.

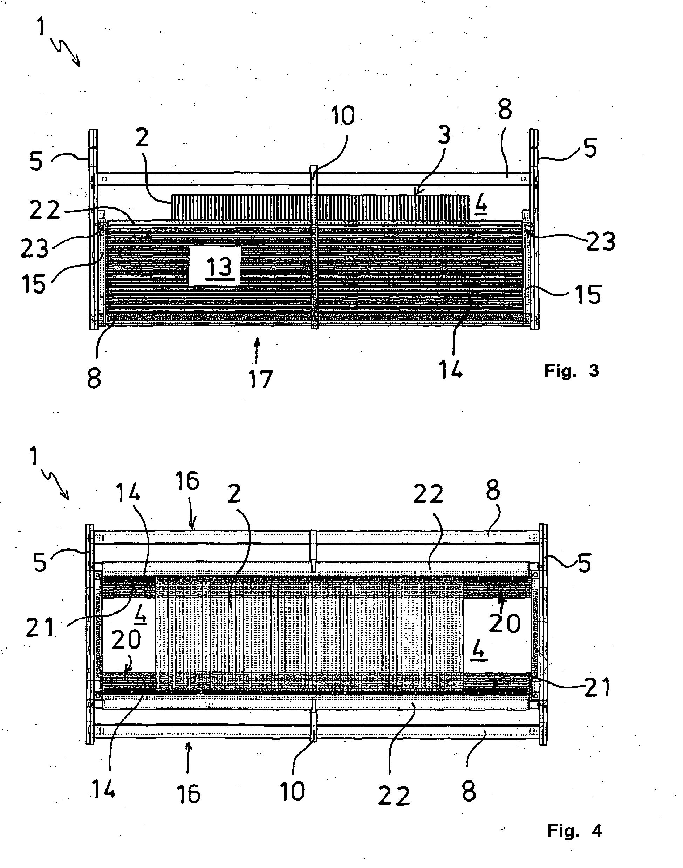

Die in den Figuren 1 - 4 dargestellte Lamellenwand 13 umgreift die Substrate 2 an unteren Rändern 18 und seitlichen Rändern 19. Dabei stehen die Substrate 2, wie es die Figuren 1, 4 besonders gut zeigen, mit ihren unteren Rändern 18 auf mindestens einer unteren Lamelle 14 auf und werden seitlich von oberen Lamellen 14 gestützt. Die unteren an der Basis 6 positionierten Lamellen 14 bilden dabei das Trageelement 20 und die oberen an den Schenkeln 7 befindlichen Lamellen 14 das Stützelement 13 des Substratträgers 1 für die Substrate 2. Das Trageelement 20 und die Stützelemente 13 halten die Substrate 2 dabei in einem geringen vertikalen Abstand zueinander lagestabil. An den Lamellen 14 sind auf der den Substraten 2 zugeordneten Seite seitlich zum Innenraum 4 abstehende Borsten 21 angebracht, die zwischen die Substrate 2 hineinreichen und so eine Berührung der Substrate 2 weitgehend verhindern.

Zum Verschieben der Lamellenwand 13 in die eine oder andere Richtung ist an einer der oberen Lamellen 14, vorzugsweise an der obersten Lamelle 14, wie den Figuren 1, 3, 4 entnehmbar, ein nach außen abstehendes Betätigungselement 22 ausgebildet. Das Betätigungselement 22 ist als Winkelschiene ausgebildet, die sich in Längsrichtung zwischen den Führungsschienen 15 der Stirnelemente 5 entlang der Lamelle 14 erstreckt. Daran kann ein Manipulator, beispielsweise im Becken eines in der Zeichnung nicht dargestellten Reinigungsbades bzw. Lösemittelbades angreifen, um das seitliche Stützelement 13 bei Bedarf in Anlage an die seitlichen Kanten 19 der Substrate 2 zu bringen.

Außerdem weist die Lamelle 14 mit dem Betätigungselement 22, wie die Figuren 1, 3 zeigen, eine lösbare Verriegelung 23 zu den Stirnelementen 5 des Substratträgers 1 auf. Die Verriegelung 23, die in unterschiedlichen Höhen mit den Stirnelementen 5 zusammenwirken kann, legt die Lamellenwand 13 in einer vorbestimmten gewünschten Höhe gegenüber den Substraten 2 an den Stirnelementen 5 lösbar fest.

## Patentansprüche

1. Substratträger (1) zur zeitweiligen lagefixierten Aufnahme einer Anzahl von plattenförmigen Substraten (2) in vertikaler Ausrichtung als liegender Stapel (3), mit einem von außen aus mehreren Richtungen zugänglichen vorzugsweise länglichen Innenraum (4), an dessen Stirnenden (2) einander gegenüberliegende, starr miteinander verbundene Stirnelemente (5) angeordnet sind, und mit mindestens einem unteren Trageelement (20) für die Substrate (2), das sich zwischen den Stirnelementen (5) erstreckt und in der Gebrauchslage des Substratträgers (1) aufgenommene Substrate (2) von unten her abstützt, **gekennzeichnet durch** seitliche Stützelemente (13) für die Substrate (2), die beidseitig in Längsrichtung zwischen den Stirnelementen (5) verlaufen und deren Höhe gegenüber dem unteren Trageelement (20) veränderbar ist.

2. Substratträger nach Anspruch 1, **dadurch gekennzeichnet, dass** die seitlichen Stützelemente (13) vorzugsweise beidseitig eine lösbare Verriegelung (23) zu den Stirnelementen (5) des Substratträgers (1) aufweisen.

3. Substratträger nach Anspruch 1 oder 2, **dadurch gekennzeichnet, dass** die Stützelemente (13) mindestens ein nach außen abstehendes Betätigungselement (22) aufweisen.

4. Substratträger nach einem der vorangegangenen Ansprüche, **dadurch gekennzeichnet, dass** die seitlichen Stützelemente (13) von einer verschiebbar geführten Lamellenwand (13) gebildet sind.

5. Substratträger nach Anspruch 4, **dadurch gekennzeichnet, dass** die Lamellenwand (13) von seitlichen Längsseiten (16) des Substratträgers (1) zu einer dem Trageelement (20) zugeordneten Unterseite (17) verschiebbar ist.

6. Substratträger nach Anspruch 5, **dadurch gekennzeichnet, dass** an der Unterseite (17) positionierte untere Lamellen (14) der Lamellenwand (13) das Trageelement (20) für die Substrate (2) bilden.

7. Substratträger nach einem der vorangegangenen Ansprüche, **dadurch gekennzeichnet, dass** die seitlichen Stützelemente (13) auf der den Substraten (2) zugeordneten Seite seitlich zum Innenraum (4) abstehende Borsten (21) aufweisen.

## Claims

1. Substrate carrier (1) for accommodating a number of plate-shaped substrates (2) in a temporarily positionally-fixed manner, vertically aligned as a horizontal stack (3), said substrate carrier having a preferably oblong interior (4) that is accessible from outside from several directions, end elements (5) that are situated opposite each other and are rigidly interconnected being located on the end faces (2) of said interior, and having at least one lower carrying element (20) for the substrates (2) which extends between the end elements (5) and in the position of use of the substrate carrier (1) supports accommodated substrates (2) from below, **characterized by** lateral support elements (13) for the substrates (2) that extend on both sides in the longitudinal direction between the end elements (5) and the height of which is modifiable in relation to the lower carrying element (20).

2. Substrate carrier according to Claim 1, **characterized in that** the lateral support elements (13) have a detachable locking means (23) to the end elements (5) of the substrate carrier (1) preferably on both sides.

3. Substrate carrier according to Claim 1 or 2, **characterized in that** the support elements (13) have at least one actuating element (22) that juts out to the outside.

4. Substrate carrier according to one of the preceding claims, **characterized in that** the lateral support elements (13) are formed by a displaceably guided lamella wall (13).

5. Substrate carrier according to Claim 4, **characterized in that** the lamella wall (13) is displaceable from lateral longitudinal sides (16) of the substrate carrier (1) to form an underside (17) associated with the carrying element (20).

6. Substrate carrier according to Claim 5, **characterized in that** lower lamellae (14) of the lamella wall (13) positioned on the underside (17) form the carrying element (20) for the substrates (2).

7. Substrate carrier according to one of the preceding claims, **characterized in that** the lateral support elements (13) have bristles (21) that jut out laterally towards the interior (4) on the side associated with the substrates (2).

## Revendications

1. Support de substrats (1) pour recevoir temporairement en les immobilisant un certain nombre de substrats (2) en forme de plaques en orientation verticale sous la forme d'une pile horizontale (3), avec une chambre intérieure (4) de préférence oblongue accessible de l'extérieur depuis plusieurs directions, aux extrémités frontales de laquelle sont disposés des éléments frontaux (5) mutuellement opposés, rigidement reliés entre eux, et avec au moins un élément porteur inférieur (20) pour les substrats (2), qui s'étend entre les éléments frontaux (5) et qui soutient par le dessous les substrats (2) reçus dans la position d'utilisation du support de substrats (1), **caractérisé par** des éléments de soutien latéraux (13) pour les substrats (2), qui s'étendent de part et d'autre en direction longitudinale entre les éléments frontaux (5) et dont la hauteur par rapport à l'élément porteur inférieur (20) peut être modifiée.

2. Support de substrats selon la revendication 1, **caractérisé en ce que** les éléments de soutien latéraux (13) présentent de préférence de part et d'autre un verrouillage amovible (23) avec les éléments frontaux (5) du support de substrats (1).

3. Support de substrats selon la revendication 1 ou 2, **caractérisé en ce que** les éléments de soutien (13) présentent au moins un élément d'actionnement (22) dépassant vers l'extérieur.

4. Support de substrats selon l'une des revendications précédentes, **caractérisé en ce que** les éléments de soutien latéraux (13) sont formés par une paroi à lamelles (13) guidée en translation.

5. Support de substrats selon la revendication 4, **caractérisé en ce que** la paroi à lamelles (13) est mobile en translation depuis des côtés longitudinaux latéraux (16) du support de substrats (1) vers un côté inférieur (17) associé à l'élément porteur (20).

6. Support de substrats selon la revendication 5, **caractérisé en ce que** des lamelles inférieures (14) de la paroi à lamelles (13), positionnées sur le côté inférieur (17), forment l'élément porteur (20) pour les substrats (2).

7. Support de substrats selon l'une des revendications précédentes, **caractérisé en ce que** les éléments de soutien latéraux (13) présentent, sur le côté associé aux substrats (2), des brosses (21) dépassant latéralement vers la chambre intérieure (4).
